(19) Europäisches Patentamt / European Patent Office / Office européen des brevets

(11) **EP 4 764 581 A1**

(12) **EUROPEAN PATENT APPLICATION**
published in accordance with Art. 153(4) EPC

(43) Date of publication:
**24.06.2026 Bulletin 2026/26**

(21) Application number: **25754599.6**

(22) Date of filing: **10.02.2025**

(51) International Patent Classification (IPC):
*G01R 35/00* (2006.01)      *G01R 31/40* (2020.01)
*G01R 31/382* (2019.01)     *G01R 31/396* (2019.01)
*G01R 31/371* (2019.01)     *H02J 7/00* (2026.01)

(52) Cooperative Patent Classification (CPC):
G01R 31/371; G01R 31/382; G01R 31/396;
G01R 31/40; G01R 35/00; H02J 7/00

(86) International application number:
**PCT/KR2025/001937**

(87) International publication number:
**WO 2025/174012 (21.08.2025 Gazette 2025/34)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **16.02.2024  KR 20240022348**

(71) Applicant: **LG Energy Solution, Ltd.
Seoul 07335 (KR)**

(72) Inventors:
• **CHOI, Soon-Ju
  Daejeon 34122 (KR)**
• **SONG, Hee-Seok
  Daejeon 34122 (KR)**

(74) Representative: **Goddar, Heinz J.
Boehmert & Boehmert
Anwaltspartnerschaft mbB
Pettenkoferstrasse 22
80336 München (DE)**

(54) **CALIBRATION APPARATUS AND CALIBRATION METHOD FOR CHARGING/DISCHARGING DEVICE**

(57)     A calibration apparatus and method for a charger/discharger are provided. The charger/discharger calibration apparatus according to the present disclosure includes acquiring reference measurement information from a reference charger/discharger, the reference measurement information being a measurement result of charge/discharge information of a first battery while a charge/discharge test is performed on the first battery by the reference charger/discharger, acquiring target measurement information from a target charger/discharger, the target measurement information being a measurement result of charge/discharge information of a second battery while the charge/discharge test is performed on the second battery by the target charger/discharger, and generating calibration information for the target charger/discharger by comparing the reference measurement information with the target measurement information.

FIG. 1

**Description**

TECHNICAL FIELD

The present disclosure relates to calibration of measurement results from a charger/discharger that charges and discharges batteries.

This application is based on and claims priority to Korean Patent Application No. 10-2024-0022348 filed on February 16, 2024 in the Republic of Korea, the disclosure of which is incorporated herein by reference.

BACKGROUND

Recently, there has been a rapid increase in the demand for portable electronic products such as laptop computers, video cameras and mobile phones, and with the extensive development of electric vehicles, accumulators for energy storage, robots and satellites, many studies are being made on high performance batteries that can be repeatedly charged and discharged.

Batteries on the market now include nickel-cadmium batteries, nickel-hydrogen batteries, nickel-zinc batteries, lithium batteries and the like, and among them, lithium batteries have little or no memory effect, and thus they are gaining more attention than nickel-based batteries for their advantages that recharging can be done whenever it is convenient, the self-discharge rate is very low and the energy density is high.

Currently, many different types of chargers/dischargers are widely used to determine the charge/discharge characteristics of batteries and/or for the battery activation process in battery manufacturing plants. For charger/dischargers to perform their functions with high accuracy for their purposes, not only high charge/discharge performance but also high measurement performance is required. Here, the charge/discharge performance refers to a measure of accuracy in the supply of the charging/discharging current or voltage to batteries as instructed by user manipulation, and the measurement performance may refer to a measure of accuracy in the measurement of battery parameters of batteries during charging and discharging.

Obviously, chargers/dischargers having higher measurement performance are expensive and require higher costs for maintenance/management/repair than chargers/dischargers having lower measurement performance. Accordingly, chargers/dischargers having modest measurement performance are used in other applications than some special applications requiring very accurate measurement. Additionally, the measurement performance may gradually decline as the chargers/dischargers degrade.

DISCLOSURE

Technical Problem

The present disclosure is designed to solve the above-described problems, and therefore the present disclosure is directed to providing an apparatus and method for calibrating measurement results from a low precision charger/-discharger ('target charger/discharger' as described below) having lower measurement performance than a high precision charger/discharger ('reference charger/discharger' as described below).

These and other objectives and advantages of the present disclosure may be understood from the following description and will become apparent from the embodiments of the present disclosure. Also, it will be easily understood that the objectives and advantages of the present disclosure may be realized by the means set forth in the appended claims and a combination thereof.

Technical Solution

A calibration method for a charger/discharger according to an aspect of the present disclosure includes acquiring reference measurement information from a reference charger/discharger, the reference measurement information being a measurement result of charge/discharge information of a first battery while a charge/discharge test is performed on the first battery by the reference charger/discharger, acquiring target measurement information from a target charger/-discharger, the target measurement information being a measurement result of charge/discharge information of a second battery while the charge/discharge test is performed on the second battery by the target charger/discharger, and generating calibration information for the target charger/discharger by comparing the reference measurement information with the target measurement information.

The reference measurement information may include first charge capacity information of the first battery by a charging procedure of the charge/discharge test. The target measurement information may include second charge capacity information of the second battery by a charging procedure of the charge/discharge test.

The generating of the calibration information for the target charger/discharger may include determining a charge capacity calibration value included in the calibration information by comparing the first charge capacity information with the second charge capacity information.

The reference measurement information may include first discharge capacity information of the first battery by a discharging procedure of the charge/discharge test. The target measurement information may include second discharge capacity information of the second battery by a discharging procedure of the charge/discharge test.

The generating of the calibration information for the target charger/discharger may include determining a discharge capacity calibration value included in the calibration information by comparing the first discharge capacity information with the second discharge capacity information.

The reference measurement information may include first charge/discharge efficiency information indicating a ratio between first charge capacity information of the first battery by a charging procedure of the charge/discharge test and first discharge capacity information of the first battery by a discharging procedure of the charge/discharge test. The target measurement information may include second charge/discharge efficiency information indicating a ratio between second charge capacity information of the second battery by a charging procedure of the charge/discharge test and second discharge capacity information of the second battery by a discharging procedure of the charge/discharge test.

The generating of the calibration information for the target charger/discharger may include determining a charge/discharge efficiency calibration value included in the calibration information by comparing the first charge/-discharge efficiency information with the second charge/discharge efficiency information.

The charger/discharger calibration method may further include determining a validity condition of the calibration information by comparing the calibration information with previous calibration information.

The charger/discharger calibration method may further include generating preliminary calibration information for the target charger/discharger by comparing the calibration information with previous calibration information.

A calibration apparatus for a charger/discharger according to another aspect of the present disclosure includes a communication unit to acquire reference measurement information from a reference charger/discharger, the reference measurement information being a measurement result of charge/discharge information of a first battery while a charge/discharge test is performed on the first battery by the reference charger/discharger, and to acquire target measurement information from a target charger/discharger, the target measurement information being a measurement result of charge/discharge information of a second battery while the charge/discharge test is performed on the second battery by the target charger/discharger, and a processor to generate calibration information for the target charger/-discharger by comparing the reference measurement information with the target measurement information.

The reference measurement information may include first charge/discharge efficiency information indicating a ratio between first charge capacity information of the first battery by a charging procedure of the charge/discharge test and first discharge capacity information of the first battery by a discharging procedure of the charge/discharge test. The target measurement information may include second charge/discharge efficiency information indicating a ratio between second charge capacity information of the second battery by a charging procedure of the charge/discharge test and second discharge capacity information of the second battery by a discharging procedure of the charge/discharge test.

The processor may determine a charge/discharge efficiency calibration value included in the calibration information by comparing the first charge/discharge efficiency information with the second charge/discharge efficiency information.

The processor may determine a validity condition of the calibration information by comparing the calibration information with previous calibration information.

The processor may generate preliminary calibration information for the target charger/discharger by comparing the calibration information with previous calibration information.

A charger/discharger calibration system according to still another aspect of the present disclosure includes the charger/discharger calibration apparatus.

Advantageous Effects

According to at least one of the embodiments of the present disclosure, the calibration information used to calibrate the measurement results from the low precision charger/discharger having lower measurement performance may be determined using the measurement information of the high precision charger/discharger.

Furthermore, according to at least one of the embodiments of the present disclosure, the validity condition of the current calibration information used to calibrate the measurement information of the low precision charger/discharger may be determined by comparing the current calibration information with the previous calibration information.

Additionally, according to at least one of the embodiments of the present disclosure, the preliminary calibration information that will be used from the time when the validity condition of the current calibration information is not met may be determined beforehand by comparing the current calibration information with the previous calibration information.

The effects of the embodiments of the present disclosure are not limited to the aforementioned effects, and these and other effects will be clearly understood by those skilled in the art from the appended claims.

## BRIEF DESCRIPTION OF THE DRAWINGS

The accompanying drawings illustrate exemplary embodiments of the present disclosure and together with the following detailed description, serve to provide a better understanding of the technical aspects of the present disclosure, and thus the present disclosure should not be construed as being limited to the drawings.

FIG. 1 is a diagram exemplarily showing the architecture of a charger/discharger calibration system according to an embodiment of the present disclosure.
FIG. 2 is a diagram exemplarily showing the configuration of a charger/discharger.
FIG. 3 is a diagram referenced in the comparison of measurement performance between a reference charger/discharger and a target charger/discharger.
FIG. 4 is a flowchart schematically showing a charger/discharger calibration method according to another embodiment of the present disclosure.
FIG. 5 is a flowchart schematically showing a charger/discharger calibration method according to still another embodiment of the present disclosure.

## BEST MODE

Hereinafter, exemplary embodiments of the present disclosure will be described in detail with reference to the accompanying drawings. Prior to the description, it should be understood that the terms or words used in the specification and the appended claims should not be construed as being limited to general and dictionary meanings, and rather, should be interpreted based on the meanings and concepts corresponding to the technical aspects of the present disclosure on the basis of the principle that the inventor is allowed to define the terms appropriately for the best explanation.

Therefore, the embodiments described herein and the illustrations shown in the drawings are exemplary embodiments of the present disclosure to describe the technical aspects of the present disclosure but not intended to be limiting, so it should be understood that a variety of other equivalents and modifications could have been made thereto at the time the application was filed.

The terms including the ordinal numbers such as "first", "second" and the like, are used to distinguish one element from another among various elements, but not intended to limit the elements by the terms.

Unless the context clearly indicates otherwise, the terms "comprise" and "include" when used in this specification, specify the presence of stated elements, but do not preclude the presence or addition of one or more other elements. Additionally, the term "unit" as used herein refers to a processing unit of at least one function or operation, and may be implemented by hardware and software either alone or in combination.

In addition, throughout this specification, it will be further understood that when an element is referred to as being "connected to" another element, it can be directly connected to the other element or intervening elements may be present.

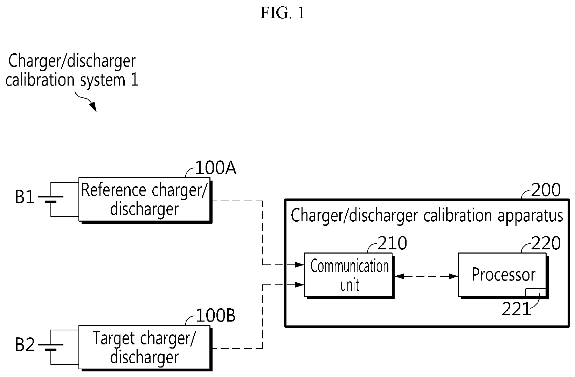

FIG. 1 is a diagram exemplarily showing the architecture of a charger/discharger calibration system 1 according to an embodiment of the present disclosure.

Referring to FIG. 1, the charger/discharger calibration system 1 includes a reference charger/discharger 100A, a target charger/discharger 100B and a calibration apparatus 200.

The reference charger/discharger 100A (also referred to as a 'high precision charger/discharger') is a charger/discharger whose measurement performance has been verified to exceed a predetermined level. The reference charger/discharger 100A may measure battery parameters at a first sampling rate. That is, the battery parameters may be measured by the reference charger/discharger 100A every first sampling period corresponding to the first sampling rate. In addition, the reference charger/discharger 100A may measure the battery parameters at a first resolution. The term resolution refers to measurable precision (for example, smallest increment) for a certain battery parameter, and as the resolution is lower, a more precise measurement value for the battery parameter may be acquired.

Specifically, at any timing when a battery is charged and discharged by the reference charger/discharger 100A, a difference or error rate between the measurement value of the battery parameter (for example, charging current, charging voltage, discharging current and/or discharging voltage as an analog signal) measured by the reference charger/discharger 100A and the actual value of the battery parameter may be within a predetermined tolerance range (a first tolerance range). In addition, for a period of time equal to or larger than a predetermined length of time during which the battery is charged and discharged by the reference charger/discharger 100A, the average value of differences or error rates between the measurement values of the battery parameter measured by the reference charger/discharger 100A and the actual values of the battery parameter may be within a predetermined tolerance range (a second tolerance range).

The target charger/discharger 100B (also referred to as a 'low precision charger/discharger') is a charger/discharger whose measurement performance is either below the predetermined level described above or requires verification to determine whether it is. Specifically, as opposed to the reference charger/discharger 100A, at any timing when a battery is charged/discharged by the target charger/discharger 100B, the difference or error rate between the measurement value of the battery parameter measured by the target charger/discharger 100B and the actual value of the battery parameter may be outside the predetermined tolerance range (the first tolerance range). In addition, for the period of time equal to or larger than the predetermined length of time during which the battery is charged and discharged by the target charger/discharger 100B, the average value of differences or error rates between the measurement values of the battery parameter measured by the reference charger/discharger 100A and the actual values of the battery parameter may be outside the predetermined tolerance range (the second tolerance range).

The target charger/discharger 100B may be designed to measure the battery parameters at a second sampling rate that is lower than the first sampling rate. Accordingly, the battery parameters may be measured by the target charger/discharger 100B every second sampling period that is longer than the first sampling period. Accordingly, a measurement error caused by a measurement gap as much as a time difference between the first sampling period and the second sampling period may build up over the measurement results from the target charger/discharger 100B. In addition, the target charger/discharger 100B may measure the battery parameters at a second resolution that is higher than the first resolution.

The calibration apparatus 200 includes a communication unit 210 and a processor 220.

The communication unit 210 is configured to support wired communication and/or wireless communication between the reference charger/discharger 100A and the target charger/discharger 100B, and the processor 220. The wired communication may include, for example, controller area network (CAN) communication, and the wireless communication may include, for example, Zigbee or Bluetooth communication. The type of communication protocol is not limited to a particular one and may include any type of communication protocol that supports wired/wireless communication between the reference charger/discharger 100A and the target charger/discharger 100B, and the processor 220.

The communication unit 210 may include a first communication channel and a second communication channel, and the two communication channels may be wiredly and/or wirelessly coupled to a communication port of the reference charger/discharger 100A and a communication port of the target charger/discharger 100B, respectively.

The communication unit 210 may collect reference measurement information from the reference charger/-discharger 100A through the first communication channel. The communication unit 210 may collect target measurement information from the target charger/discharger 100B through the second communication channel.

The reference measurement information may indicate the measurement results for charge/discharge information of the first battery B1 during a charge/discharge test of the first battery B1 by the reference charger/discharger 100A.

The target measurement information may indicate the measurement results for charge/ discharge information of the second battery B2 during the charge/discharge test of the second battery B2 by the reference charger/discharger 100A.

The first battery B1 and the second battery B2 may be pre-verified to have the same electrochemical characteristics.

The charge/discharge test may refer to a test involving a predetermined number (for example, 600) of repeated charge/discharge cycles. The charge/discharge cycle includes a charging procedure and a discharging procedure. In the same charge/discharge cycle, a rest period (a first rest period) may be present between the charging procedure and the discharging procedure. In addition, a rest period (a second rest period) may be present between the discharging procedure of a charge/discharge cycle and the charging procedure of the next charge/discharge cycle. The rest period refers to a period of time during which charging and discharging are stopped.

The charging procedure may be a procedure of charging the battery according to a constant current (CC)-constant voltage (CV) charging protocol over a predetermined voltage range. For the CC charging of the charging procedure, a current of a first current rate (for example, 0.05C) may be set. Until the voltage of the battery reaches the upper limit (a predetermined cut-off voltage) of the predetermined voltage range from the lower limit, the CC charging may be done and then changed to CV charging. The CV charging may be done until the charging current of the battery decreases below a predetermined cut-off current from the time when the voltage of the battery reaches the cut-off voltage. The cut-off current may be, for example, 1/10 of the current rate used in the CC charging.

The discharging procedure may be a procedure of discharging the battery at a constant current over a predetermined voltage range. In the CC discharging of the discharging procedure, a current of a second current rate (for example, 0.33C) may be set. The second current rate may be higher than the first current rate. For example, the first current rate = 0.05C, and the second current rate = 0.33C.

The processor 220 may be implemented in hardware using at least one of application specific integrated circuits (ASICs), digital signal processors (DSPs), digital signal processing devices (DSPDs), programmable logic devices (PLDs), field programmable gate arrays (FPGAs), microprocessors or electrical units for performing other functions.

The processor 220 may have a memory 221. The memory 221 may include, for example, at least one type of storage medium of flash memory type, hard disk type, Solid State Disk (SSD) type, Silicon Disk Drive (SDD) type, multimedia card micro type, random access memory (RAM), static random access memory (SRAM), read-only memory (ROM), electrically erasable programmable read-only memory (EEPROM) or programmable read-only memory (PROM). The memory 221 may store data and programs required for the operations by the processor 220 as described below. The memory may store data indicating the results of the operations performed by the processor 220.

The processor 220 may control the communication unit 210 to transmit an operation command to each of the reference charger/discharger 100A and the target charger/discharger 100B. In response to the operation command, the reference charger/discharger 100A may perform the charge/discharge test on the first battery B1 and transmit the reference measurement information to the calibration apparatus 200. In response to the operation command, the target charger/discharger 100B may perform the charge/discharge test on the second battery B2 and transmit the target measurement information to the calibration apparatus 200.

Each of the reference measurement information and the target measurement information may include a measurement dataset (at least one of a cumulative charge capacity value, a cumulative discharge capacity value, a cumulative charge/discharge capacity value or a charge/discharge efficiency value) every reference number of charge/-discharge cycles. The set number of cycles may be equal to a value obtained by multiplying the reference number of cycles by a reference value (a predetermined natural number). For example, the set number of cycles = 600, and the reference number of cycles = 100. The set number of cycles may be preset to prevent over-aging in the reference charger/discharger 100A and the target charger/discharger 100B beyond a threshold level.

Every reference number of charge/discharge cycles, the measurement dataset may be based on at least one of the sum of charge capacity values or the sum of discharge capacity values measured in the charging procedures and discharging procedures of the same charge/discharge cycles. For reference, the charge capacity value in a charging process may be determined by ampere counting involving periodically integrating the measurements of the charging current in the charging process. Likewise, the discharge capacity value in a discharging process may be determined by ampere counting involving periodically integrating the measurements of the discharging current in the discharging process.

For example, the cumulative charge capacity value of the first to 100th charge/discharge cycles may indicate the total charge capacity supplied to the battery through the charging procedure that has been done 100 times in the first to 100th charge/discharge cycles. The cumulative discharge capacity value of the first to 100th charge/discharge cycles may indicate the total discharge capacity released from the battery through the discharging procedure that has been done 100 times in the first to 100th charge/discharge cycles. The cumulative charge/discharge capacity value of the first to 100th charge/discharge cycles may indicate a difference (for example, 0.02 Ah) between the cumulative charge capacity value (for example, 0.30 Ah) in the first to 100th charge/discharge cycles and the cumulative discharge capacity value (for example, 0.28 Ah) in the first to 100th charge/discharge cycles. The charge/discharge efficiency value of the first to 100th charge/discharge cycles may indicate a ratio of any one of the cumulative charge capacity value and the cumulative discharge capacity value to the other, and may be referred to as 'Coulombic efficiency'.

Each of the reference measurement information and the target measurement information may include the same number of cumulative charge capacity values, cumulative discharge capacity values, cumulative charge/discharge capacity values and/or charge/discharge efficiency values as the reference value.

The reference measurement information may include at least one of first charge capacity information, first discharge capacity information, first charge/discharge capacity information or first charge/discharge efficiency information. The first charge capacity information, the first discharge capacity information, the first charge/discharge capacity information and the first charge/discharge efficiency information may indicate the cumulative charge capacity value, the cumulative discharge capacity value, the cumulative charge/discharge capacity value and the charge/discharge efficiency value of the first battery B1 by the charge/discharge test, respectively.

The target measurement information may include at least one of second charge capacity information, second discharge capacity information, second charge/discharge capacity information or second charge/discharge efficiency information. The second charge capacity information, the second discharge capacity information, the second charge/-discharge capacity information and the second charge/discharge efficiency information may indicate the cumulative charge capacity value, the cumulative discharge capacity value, the cumulative charge/discharge capacity value and the charge/discharge efficiency value of the second battery B2 by the charge/discharge test, respectively.

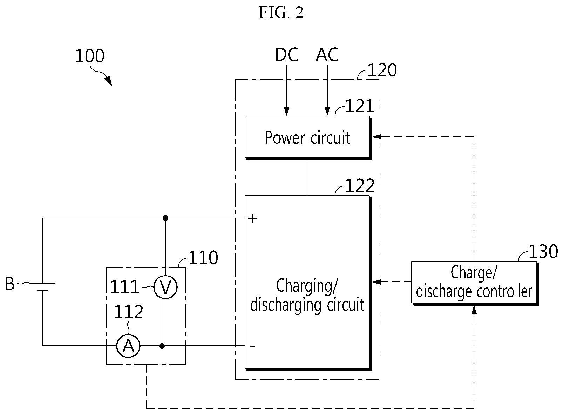

FIG. 2 is a diagram exemplarily showing the configuration of the charger/discharger. The description of the charger/discharger 100 as described below with reference to FIG. 2 may be shared with the reference charger/discharger 100A and the target charger/discharger 100B shown in FIG. 1.

Referring to FIG. 2, the charger/discharger 100 includes a measuring unit 110, a charging/discharging unit 120 and a charge/discharge controller 130.

The charging/discharging unit 120 is provided to repeatedly perform the charging/discharging cycle on the battery B. The battery B may correspond to the first battery B1 or the second battery B1 of FIG. 1.

The charging/discharging unit 120 has a charging function, a discharging function and a resting function, and is configured to selectively perform one of the charging function, the discharging function and the resting function according to the protocol and conditions of each of the charging procedure and the discharging procedure specified in the charge/discharge test.

The charging/discharging unit 120 includes a power circuit 121 and a charging/discharging circuit 122.

The power circuit 121 is configured to convert power from an alternating current (AC) power source and/or a direct current (DC) power source to DC having a predetermined voltage level that meets the input specifications of the charging/discharging circuit 122. The power circuit 121 may include one of known AC-DC converter and DC-DC converter or a combination of two of them.

The charging/discharging circuit 122 may have a pair of charge/discharge terminals (+, -) connected to the positive electrode and the negative electrode of the battery B, respectively, and may charge or discharge the battery B in response to a command from the charge/discharge controller 130. The charge/discharge circuit 122 may include one of known CC circuit and CV circuit or a combination of two of them.

When the operation command is received through the communication port, the charge/discharge controller 130 controls the charging/discharging circuit 122 and the power circuit 121 to repeatedly perform the charge/discharge cycle the set number of times.

The measuring unit 110 may measure the battery parameters of the battery during the charge/discharge test by the charging/discharging unit 120, and transmit the measurement value to the charge/discharge controller 130.

The measuring unit 110 includes a voltage sensor 111 and a current sensor 112. The voltage sensor 111 is connected to the positive electrode and the negative electrode of the battery through a pair of voltage sensing lines, and measures the voltage of the battery and generates (outputs) a signal indicating a sample value of the measured voltage.

The current sensor 112 is installed on the charging/discharging path connecting the battery to the charging/-discharging circuit 122, and measures the charging current and/or the discharging current and generates (outputs) a signal indicating a sample value of the measured current. For example, the current sensor 112 may include a known current detection device such as a shunt resistor and/or a Hall sensor. The voltage sensor 111 and the current sensor 112 may be combined into a single chip.

The charge/discharge controller 130 is operably coupled to the measuring unit 110 and the charging/discharging unit 120. Here, "operably coupled" refers to direct/indirect connection to enable signal transmission and reception in one or two directions.

The charge/discharge controller 130 may be implemented in hardware using at least one of application specific integrated circuits (ASICs), digital signal processors (DSPs), digital signal processing devices (DSPDs), programmable logic devices (PLDs), field programmable gate arrays (FPGAs), microprocessors 220 or electrical units for performing other functions.

The charge/discharge controller 130 may have a memory. The memory may include, for example, at least one type of storage medium of flash memory type, hard disk type, Solid State Disk (SSD) type, Silicon Disk Drive (SDD) type, multimedia card micro type, random access memory (RAM), static random access memory (SRAM), read-only memory (ROM), electrically erasable programmable read-only memory (EEPROM) or programmable read-only memory (PROM).

The measurement values generated during the charge/discharge test may be recorded in the memory. After the charge/discharge test is completed, the measurement information including or based on the measurement values recorded in the memory may be transmitted to the calibration apparatus 200 through the communication port of the charge/discharge controller 130.

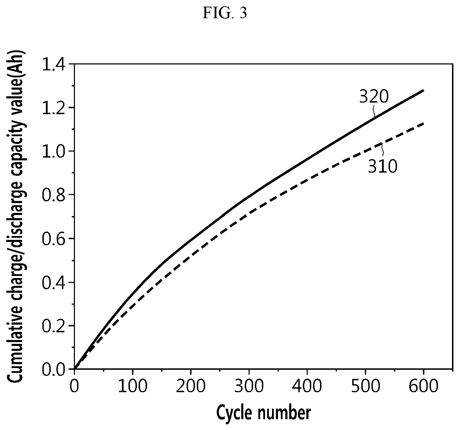

FIG. 3 is a diagram referenced in the comparison of measurement performance between the reference charger/discharger 100A and the target charger/discharger 100B. To help understanding, description will be based on the cumulative charge/discharge capacity value among the measurement result values for many different types of parameters (cumulative charge capacity value, cumulative discharge capacity value, cumulative charge/discharge capacity value and charge/discharge efficiency value).

Referring to FIG. 3, a curve 310 shows a change in cumulative charge/discharge capacity value over the repeated charge/discharge cycles of the charge/discharge test for the first battery B1 by the reference charger/discharger 100A, and a curve 320 shows a change in cumulative charge/discharge capacity value over the repeated charge/-discharge cycles of the charge/discharge test for the second battery B2 by the target charger/discharger 100B. For reference, the cumulative charge/discharge capacity value may increase by 1 each time a single charge/discharge cycle is completed.

It should be noted that a difference in measurement performance between the reference charger/discharger 100A and the target charger/discharger 100B comes from a difference of Y-axis value (i.e., cumulative charge/discharge capacity value) between the curve 310 and the curve 320 at the same X-axis value (i.e., cycle number), rather than the shape of each of the curve 310 and the curve 320. The comparison of the curve 310 and the curve 320 shows that as the cycle number increases, the difference between the curve 310 and the curve 320 gradually increases in the Y-axis direction.

When (i) the measurement value of the charging current measured by the target charger/discharger 100B is larger than the actual value, or (ii) the measurement value of the discharging current measured by the target charger/-

discharger 100B is smaller than the actual value, the difference between the curve 310 and the curve 320 may have a tendency shown in FIG. 3.

Through many experimental results, the inventors discovered that the difference between the curve 310 and the curve 320 (based on the Y-axis) has an approximately linear change as a function of cycle number.

Meanwhile, in both the curve 310 and the curve 320, the cumulative charge/discharge capacity value increases slowly with the increasing cycle number. The reason is, for example, (i) an increase in charge capacity and a decrease in discharge capacity due to the formation of by-products of charge/discharge reactions, such as Solid Electrolyte Interphase (SEI) in the early stage of battery life, and (ii) a decline in full charge capacity (FCC) as the battery degrades.

For reference, some of the charge capacity supplied to the battery by the charger/discharger may not be stored in the battery and may be used, due to heat loss. Accordingly, the actual increase in the charge capacity of the battery may be smaller than the charge capacity supplied from the charger/discharger. In addition, capacity loss may occur during discharging of the battery by the charger/discharger. Accordingly, the discharge capacity measured by the charger/-discharger may be smaller than the actual discharge capacity of the battery.

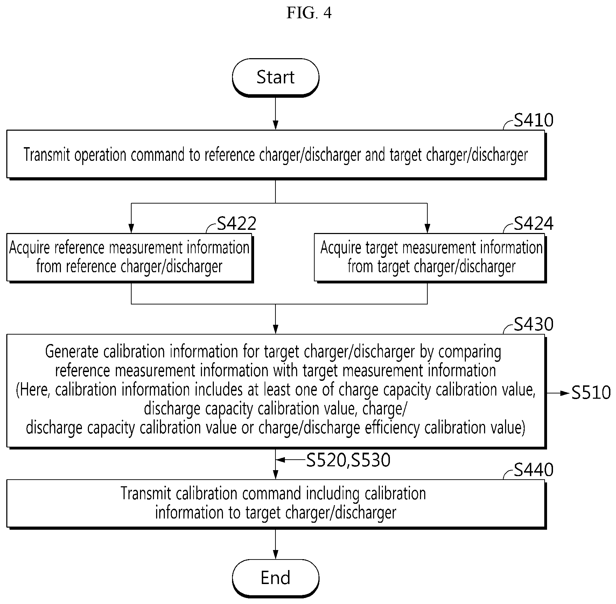

FIG. 4 is a flowchart schematically showing a charger/discharger calibration method according to another embodiment of the present disclosure. The method of FIG. 4 may be performed by the calibration apparatus 200 of FIG. 1.

Referring to FIGS. 1 to 4, in step S410, the processor 220 controls the communication unit 210 to transmit the operation command to the reference charger/discharger 100A and the target charger/discharger 100B. The operation command may be transmitted to the reference charger/discharger 100A and the target charger/discharger 100B through the first communication channel and the second communication channel of the communication unit 210. When the step S410 is performed, the charge/discharge test of the reference charger/discharger 100A for the first battery B1 and the charge/discharge test of the target charger/discharger 100B for the second battery B2 get started. The operation command may not be transmitted to the reference charger/discharger 100A and the target charger/discharger 100B at the same time. For example, the communication unit 210 may transmit the operation command to the reference charger/discharger 100A first, and then transmit the operation command to the target charger/discharger 100B.

In step S422, the processor 220 acquires (collects) the reference measurement information from the reference charger/discharger 100A. When the charge/discharge test for the first battery B1 is completed, the reference charger/-discharger 100A may transmit, to the communication unit 210, the reference measurement information which is the measurement results of the charge/discharge information of the first battery B1 recorded for the period of time during which the charge/discharge test is performed.

In step S424, the processor 220 acquires (collects) the target measurement information from the target charger/discharger 100B. When the charge/discharge test for the second battery B2 is completed, the reference charger/discharger 100A may transmit, to the communication unit 210, the target measurement information which is the measurement results of the charge/discharge information of the second battery B2 recorded for the period of time during which the charge/discharge test is performed.

In step S430, the processor 220 generates calibration information for the target charger/discharger 100B by comparing the reference measurement information with the target measurement information. The calibration information may include at least one of a charge capacity calibration value, a discharge capacity calibration value, a charge/discharge capacity calibration value or a charge/discharge efficiency calibration value.

When the reference measurement information includes the first charge capacity information and the target measurement information includes the second charge capacity information, the processor 220 may determine the charge capacity calibration value by comparing the first charge capacity information with the second charge capacity information. The charge capacity calibration value may indicate a ratio of any one of the two cumulative charge capacity values of the first charge capacity information and the second charge capacity information to the other.

When the reference measurement information includes the first discharge capacity information and the target measurement information includes the second discharge capacity information, the processor 220 may determine the discharge capacity calibration value by comparing the first discharge capacity information with the second discharge capacity information. The discharge capacity calibration value may indicate a ratio of any one of the two cumulative discharge capacity values of the first discharge capacity information and the second discharge capacity information to the other.

When the reference measurement information includes the first charge/discharge capacity information and the target measurement information includes the second charge/discharge capacity information, the processor 220 may determine the charge/discharge capacity calibration value by comparing the first charge/discharge capacity information with the second charge/discharge capacity information. The charge/discharge capacity calibration value may indicate a ratio of any one of the two cumulative charge/discharge capacity values of the first charge/discharge capacity information and the second charge/discharge capacity information to the other.

When the reference measurement information includes the first charge/discharge efficiency information and the target measurement information includes the second charge/discharge efficiency information, the processor 220 may determine the charge/discharge efficiency calibration value by comparing the first charge/discharge efficiency information with the second charge/discharge efficiency information. The charge/discharge efficiency calibration value may indicate a ratio of any one of the two cumulative charge/discharge efficiency values of the first charge/discharge efficiency information and the second charge/discharge efficiency information to the other.

The method of FIG. 4 may further include step S440. In the step S440, the processor 220 controls the communication unit 210 to transmit a calibration command including the calibration information determined in the step S430 to the target charger/discharger 100B.

After the calibration command from the calibration apparatus 200 is received, the charge/discharge controller 130 of the target charger/discharger 100B may calibrate measurement information generated during charging/discharging of another battery based on the received calibration information.

Assume that the charge/discharge efficiency calibration value included in the received calibration information is 97.7%, and the charge/discharge efficiency value of the other battery determined by the target charger/discharger 100B is 85.4%. The charge/discharge efficiency value of the other battery may be calibrated to $85.4 \times 97.7\% \fallingdotseq 8.34\%$.

Meanwhile, as described above, the measurement performance of the target charger/discharger 100B may gradually decline as the target charger/discharger 100B degrades. Accordingly, the validity of the calibration information determined through the method described above with reference to FIG. 4 is not permanent, so it is necessary to update the calibration information as the target charger/discharger 100B degrades. However, while the target charger/discharger 100B performs the charge/discharge test to acquire new target measurement information required for the calibration information updates, the target charger/discharger 100B cannot be used for its original purpose (for example, battery activation). In addition, when the target charger/discharger 100B performs the charge/discharge test so frequently to update the calibration information, the measurement performance of the target charger/discharger 100B may degrade fast.

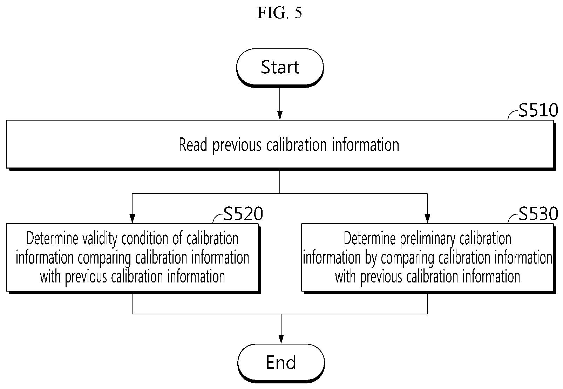

FIG. 5 is a flowchart schematically showing the charger/discharger calibration method according to still another embodiment of the present disclosure. The method of FIG. 5 relates to the subsequent procedure of the step S440 of FIG. 4 and may be performed by the calibration apparatus 200 of FIG. 1.

The method of FIG. 5 is performed on the condition that the calibration process for the target charger/discharger 100B according to the method of FIG. 4 has already been done at least twice. Accordingly, when performing the method of FIG. 5, previous calibration information is recorded in the memory of the calibration apparatus 200. The previous calibration information may be the most recently determined calibration information by the method of FIG. 4 on the basis of the present time. For example, under the assumption that m is a natural number of 2 or greater, when first to m-th calibration information are recorded in the memory by performing the method of FIG. 4 a total of m times, m-th calibration information may be 'current calibration information', and m-1-th calibration information may be 'previous calibration information'.

Referring to FIG. 5, in step S510, the processor 220 reads the previous calibration information from the memory.

In step S520, the processor 220 may determine a validity condition of the calibration information determined in the step S440 by comparing the calibration information determined in the step S440 (referred to as 'current calibration information') with the previous calibration information. The validity condition may include at least one of valid time or valid total charge/discharge capacity.

In the case where the validity condition includes the valid time, the validity condition is not met when the valid time passes from the time when the current calibration information was determined. That is, the current calibration information may be set to be used to calibrate the measurement information of the target charger/discharger 100B only until the valid time passes from the time when the current calibration information was determined.

In the case where the valid condition includes the valid total charge/discharge capacity, the valid condition is not met when the increase in the total charge/discharge capacity of the target charger/discharger 100B reaches the valid total charge/discharge capacity. That is, the current calibration information may be set to be used to calibrate the measurement information of the target charger/discharger 100B only until the increase in the total charge/discharge capacity of the target charger/discharger 100B reaches the valid total charge/discharge capacity from the time when the current calibration information was determined.

In step S530, the processor 220 generate preliminary calibration information for the target charger/discharger 100B by comparing the calibration information determined in the step S440 (referred to as 'current calibration information') with the previous calibration information. The preliminary calibration information may be used to calibrate the measurement information of the target charger/discharger 100B from an unspecified time when the current calibration information will not meet the validity condition.

Specifically, in the same way as the current calibration information, the preliminary calibration information includes a calibration value for at least one type of the charge capacity information, the discharge capacity information, the charge/discharge capacity information or the charge/discharge efficiency information.

As the target charger/discharger 100B degrades, its measurement performance declines, so the calibration value for a specific type of measurement information included in the preliminary calibration information may be larger than the calibration value for the same type of measurement information included in the current calibration information.

Each of the valid condition and the preliminary calibration information may be determined based on a difference between two specific types of calibration values of the previous calibration information and the current calibration information. In addition, each of the valid condition and the preliminary calibration information may be determined further based on at least one of the time length of the working period of time from the time when the previous calibration information was determined to the time when the current calibration information was determined, or the total charge/discharge capacity of the target charger/discharger 100B for the working period of time.

For a period of time, the total charge/discharge capacity may indicate the sum of the cumulative charge capacity and the cumulative discharge capacity, as opposed to the cumulative charge/discharge capacity. For example, when the cumulative charge capacity is 10 Ah and the cumulative discharge capacity is 9 Ah for a certain period of time, the cumulative charge/discharge capacity is 1 Ah, and the total charge/discharge capacity is 11 Ah.

The following equations are used to describe a relationship between at least two of the previous calibration information, the current calibration information, the validity condition and the preliminary calibration information by way of example.

<Equation 1>

$$t_{valid} = f_1(E) + f_2(\Delta t) + f_3(\Delta Q)$$

In Equation 1, E denotes a difference (i.e., the measurement error of the target charger/discharger 100B) between two calibration values for a specific type of measurement information in the previous calibration information and the current calibration information, $\Delta t$ denotes the time length of the working period of time, $\Delta Q$ denotes the total charge/discharge capacity of the target charger/discharger 100B for the working period of time, and $t_{valid}$ denotes the valid time. Each of $f_1$, $f_2$ and $f_3$ is the function that defines a negative correspondence relationship between the input value and the output value, and the unit of the output value in each function is time. As the input value E is larger, $f_1$ may output a smaller time value. As the input value $\Delta t$ is larger, $f_2$ may output a smaller time value. As the input value $\Delta Q$ is larger, $f_3$ may output a smaller time value. The sum of the time values outputted from $f_1$, $f_2$ and $f_3$ may be determined as $t_{valid}$.

<Equation 2>

$$\Delta Q_{valid} = f_4(E) + f_5(\Delta t) + f_6(\Delta Q)$$

In Equation 2, E, $\Delta t$ and $\Delta Q$ as the input values for the functions $f_4$, $f_5$ and $f_6$, respectively, are the same as those of Equation 1, and $\Delta Q_{valid}$ denotes the valid total charge/discharge capacity. Each of $f_4$, $f_5$ and $f_6$ is the function that defines a negative correspondence relationship between the input value and the output value, and the unit of the output value in each function is capacity. As the input value E is larger, $f_4$ may output a smaller capacity value. As the input value $\Delta t$ is larger, $f_5$ may output a smaller capacity value. As the input value $\Delta Q$ is larger, $f_6$ may output a smaller capacity value. The sum of the capacity values outputted from $f_4$, $f_5$ and $f_6$ may be determined as $\Delta Q_{valid}$.

<Equation 3>

$$\Delta C_{pre} = \Delta C_{current} + f_7(E) + f_8(\Delta t) + f_9(\Delta Q)$$

In Equation 3, E, $\Delta t$ and $\Delta Q$ as the input values for the functions $f_7$, $f_8$ and $f_9$, respectively, are the same as those of Equation 1. $\Delta C_{current}$ denotes the calibration value for the specific type of measurement information included in the current calibration information, and $\Delta C_{pre}$ denotes the calibration value for the specific type of measurement information included in the preliminary calibration information. Each of the functions $f_7$, $f_8$ and $f_9$ is the function that defines a positive correspondence relationship between the input value and the output value, and the unit of the output value in each function is the same as the unit of $\Delta C_{current}$. As the input value E is larger, $f_7$ may output a larger calibration value. As the input value $\Delta t$ is larger, $f_8$ may output a larger calibration value. As the input value $\Delta Q$ is larger, $f_9$ may output a large calibration value. The sum of the calibration values outputted from $f_7$, $f_8$ and $f_9$ may be determined as $\Delta C_{Pre}$.

At least one of the valid condition determined in the step S520 or the preliminary calibration information determined in the step S530 may be included in the calibration command which in turn, may be transmitted to the target charger/discharger 100B in the step S440.

The target charger/discharger 100B may transmit a message to the calibration apparatus 200 to notify that the calibration information needs updating when the validity condition of the received calibration information is not met.

The embodiments of the present disclosure as described above are not embodied only through the apparatus and method, and may be implemented through programs that perform the functions corresponding to the exemplary configurations of the present disclosure or recording media having the programs recorded thereon, and such implementation may be easily achieved by those skilled in the art from the disclosure of the embodiments previously described.

Although the present disclosure has been hereinabove described with regard to certain embodiments and drawings, the present disclosure is not limited thereto and it is obvious to those skilled in the art that various modifications and changes may be made thereto within the technical aspects of the present disclosure and the scope of the appended claims and their equivalents.

Additionally, as many substitutions, modifications and changes may be made to the present disclosure as described above by those skilled in the art without departing from the technical aspects of the present disclosure, the present disclosure is not limited by the above-described embodiments and the accompanying drawings, and some or all of the embodiments may be selectively combined to allow various modifications.

**Claims**

1. A charger/discharger calibration method for calibrating a charger/discharger, comprising:

   acquiring reference measurement information from a reference charger/discharger, the reference measurement information being a measurement result of charge/discharge information of a first battery while a charge/discharge test is performed on the first battery by the reference charger/discharger;
   acquiring target measurement information from a target charger/discharger, the target measurement information being a measurement result of charge/discharge information of a second battery while the charge/discharge test is performed on the second battery by the target charger/discharger; and
   generating calibration information for the target charger/discharger by comparing the reference measurement information with the target measurement information.

2. The charger/discharger calibration method according to claim 1,

   wherein the reference measurement information includes first charge capacity information of the first battery by a charging procedure of the charge/discharge test, and
   wherein the target measurement information includes second charge capacity information of the second battery by a charging procedure of the charge/discharge test.

3. The charger/discharger calibration method according to claim 2,
   wherein the generating of the calibration information for the target charger/discharger comprises:
   determining a charge capacity calibration value included in the calibration information by comparing the first charge capacity information with the second charge capacity information.

4. The charger/discharger calibration method according to claim 1,

   wherein the reference measurement information includes first discharge capacity information of the first battery by a discharging procedure of the charge/discharge test, and
   wherein the target measurement information includes second discharge capacity information of the second battery by a discharging procedure of the charge/discharge test.

5. The charger/discharger calibration method according to claim 4,
   wherein the generating of the calibration information for the target charger/discharger comprises:
   determining a discharge capacity calibration value included in the calibration information by comparing the first discharge capacity information with the second discharge capacity information.

6. The charger/discharger calibration method according to claim 1,

   wherein the reference measurement information includes first charge/discharge efficiency information indicating a ratio between first charge capacity information of the first battery by a charging procedure of the charge/discharge test and first discharge capacity information of the first battery by a discharging procedure of the charge/discharge test, and

wherein the target measurement information includes second charge/discharge efficiency information indicating a ratio between second charge capacity information of the second battery by a charging procedure of the charge/discharge test and second discharge capacity information of the second battery by a discharging procedure of the charge/discharge test.

7. The charger/discharger calibration method according to claim 6,
wherein the generating of the calibration information for the target charger/discharger comprises:
determining a charge/discharge efficiency calibration value included in the calibration information by comparing the first charge/discharge efficiency information with the second charge/discharge efficiency information.

8. The charger/discharger calibration method according to claim 1, further comparing:
determining a validity condition of the calibration information by comparing the calibration information with previous calibration information.

9. The charger/discharger calibration method according to claim 1, further comparing:
generating preliminary calibration information for the target charger/discharger by comparing the calibration information with previous calibration information.

10. A charger/discharger calibration apparatus for calibrating a charger/discharger, comprising:

a communication unit to acquire reference measurement information from a reference charger/discharger, the reference measurement information being a measurement result of charge/discharge information of a first battery while a charge/discharge test is performed on the first battery by the reference charger/discharger, and to acquire target measurement information from a target charger/discharger, the target measurement information being a measurement result of charge/discharge information of a second battery while the charge/discharge test is performed on the second battery by the target charger/discharger; and
a processor to generate calibration information for the target charger/discharger by comparing the reference measurement information with the target measurement information.

11. The charger/discharger calibration apparatus according to claim 10,

wherein the reference measurement information includes first charge/discharge efficiency information indicating a ratio between first charge capacity information of the first battery by a charging procedure of the charge/discharge test and first discharge capacity information of the first battery by a discharging procedure of the charge/discharge test, and
wherein the target measurement information includes second charge/discharge efficiency information indicating a ratio between second charge capacity information of the second battery by a charging procedure of the charge/discharge test and second discharge capacity information of the second battery by a discharging procedure of the charge/discharge test.

12. The charger/discharger calibration apparatus according to claim 11,
wherein the processor is configured to:
determine a charge/discharge efficiency calibration value included in the calibration information by comparing the first charge/discharge efficiency information with the second charge/discharge efficiency information.

13. The charger/discharger calibration apparatus according to claim 10,
wherein the processor is configured to:
determine a validity condition of the calibration information by comparing the calibration information with previous calibration information.

14. The charger/discharger calibration apparatus according to claim 10,
wherein the processor is configured to:
generate preliminary calibration information for the target charger/discharger by comparing the calibration information with previous calibration information.

15. A charger/discharger calibration system comprising the charger/discharger calibration apparatus according to any one of claims 10 to 14.

FIG. 1

Charger/discharger
calibration system 1

B1 ⊣⊢ [Reference charger/ discharger] ⌐100A

[Charger/discharger calibration apparatus] ⌐200

[Communication unit] ⌐210 ◄ - - ► [Processor] ⌐220
221

B2 ⊣⊢ [Target charger/ discharger] ⌐100B

FIG. 2

FIG. 3

FIG. 4

```
                              ┌─────────┐
                              │  Start  │
                              └─────────┘
                                   │
                                   ▼                              ╭S410
┌────────────────────────────────────────────────────────────────────────┐
│ Transmit operation command to reference charger/discharger and target    │
│ charger/discharger                                                       │
└────────────────────────────────────────────────────────────────────────┘
                │                                    │
                ▼          ╭S422                      ▼          ╭S424
┌────────────────────────────────┐    ┌────────────────────────────────┐
│ Acquire reference measurement  │    │ Acquire target measurement     │
│ information from reference      │    │ information from target        │
│ charger/discharger             │    │ charger/discharger             │
└────────────────────────────────┘    └────────────────────────────────┘
                │                                    │
                └──────────────────┬─────────────────┘
                                   ▼                              ╭S430
┌────────────────────────────────────────────────────────────────────────┐
│       Generate calibration information for target charger/discharger by   │
│       comparing reference measurement information with target             │
│       measurement information                                            │──► S510
│ (Here, calibration information includes at least one of charge capacity   │
│ calibration value, discharge capacity calibration value, charge/          │
│ discharge capacity calibration value or charge/discharge efficiency       │
│ calibration value)                                                       │
└────────────────────────────────────────────────────────────────────────┘
                                   │◄── S520,S530
                                   ▼                              ╭S440
┌────────────────────────────────────────────────────────────────────────┐
│       Transmit calibration command including calibration                  │
│       information to target charger/discharger                            │
└────────────────────────────────────────────────────────────────────────┘
                                   │
                                   ▼
                              ┌─────────┐
                              │   End   │
                              └─────────┘
```

FIG. 5

```
              ┌─────────┐
              │  Start  │
              └────┬────┘
                   │                                          ┌─S510
    ┌──────────────▼──────────────────────────────────────┐
    │        Read previous calibration information         │
    └──────────────┬──────────────────────────────────────┘
         ┌─────────┴──────────┐
   ┌─S520│                    │┌─S530
┌──────▼───────────────┐ ┌───▼──────────────────────┐
│ Determine validity   │ │ Determine preliminary    │
│ condition of         │ │ calibration information  │
│ calibration          │ │ by comparing calibration │
│ information comparing │ │ information with         │
│ calibration          │ │ previous calibration     │
│ information with     │ │ information              │
│ previous calibration │ │                          │
│ information          │ │                          │
└──────┬───────────────┘ └───┬──────────────────────┘
       └─────────┬───────────┘
              ┌──▼──────┐
              │   End   │
              └─────────┘
```

## INTERNATIONAL SEARCH REPORT

| International application No. |
| --- |
| **PCT/KR2025/001937** |

| A. | CLASSIFICATION OF SUBJECT MATTER |
| --- | --- |

**G01R 35/00**(2006.01)i; **G01R 31/40**(2006.01)i; **G01R 31/382**(2019.01)i; **G01R 31/396**(2019.01)i; **G01R 31/371**(2019.01)i; **H02J 7/00**(2006.01)i

According to International Patent Classification (IPC) or to both national classification and IPC

| B. | FIELDS SEARCHED |
| --- | --- |

Minimum documentation searched (classification system followed by classification symbols)

G01R 35/00(2006.01); G01R 31/36(2006.01); G01R 31/382(2019.01); G01R 31/392(2019.01); H01M 10/44(2006.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 충방전기(charge/discharge device), 교정(calibration), 비교(comparison), 테스트(test)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| A | KR 10-1979542 B1 (PNE SOLUTION CO., LTD.) 15 May 2019 (2019-05-15)<br>See paragraphs [0036]-[0076] and figures 1-4b. | 1-15 |
| A | KR 10-2016-0118126 A (CHROMA ATE INC.) 11 October 2016 (2016-10-11)<br>See paragraphs [0061]-[0063] and figure 6. | 1-15 |
| A | JP 2023-112925 A (NITTETSU TEXENG CO., LTD.) 15 August 2023 (2023-08-15)<br>See paragraphs [0013]-[0026] and figures 2-3. | 1-15 |
| A | KR 10-2022-0048782 A (LG ENERGY SOLUTION, LTD.) 20 April 2022 (2022-04-20)<br>See paragraphs [0077]-[0090] and figures 4-5. | 1-15 |
| A | CN 111751736 A (ESPEC CORP.) 09 October 2020 (2020-10-09)<br>See claim 1 and figures 1-3. | 1-15 |

☐ Further documents are listed in the continuation of Box C.  ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **13 May 2025** | **14 May 2025** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2025/001937**

| Patent document cited in search report | | | Publication date (day/month/year) | Patent family member(s) | | | Publication date (day/month/year) |
|---|---|---|---|---|---|---|---|
| KR | 10-1979542 | B1 | 15 May 2019 | CN | 110346744 | A | 18 October 2019 |
| | | | | CN | 110346744 | B | 29 March 2022 |
| KR | 10-2016-0118126 | A | 11 October 2016 | JP | 2016-195528 | A | 17 November 2016 |
| | | | | JP | 6243396 | B2 | 06 December 2017 |
| | | | | KR | 10-1743106 | B1 | 02 June 2017 |
| | | | | TW | 201636632 | A | 16 October 2016 |
| | | | | TW | I534447 | B | 21 May 2016 |
| | | | | US | 2016-0291080 | A1 | 06 October 2016 |
| | | | | US | 9841737 | B2 | 12 December 2017 |
| JP | 2023-112925 | A | 15 August 2023 | JP | 2023-113103 | A | 15 August 2023 |
| | | | | JP | 7117464 | B1 | 12 August 2022 |
| KR | 10-2022-0048782 | A | 20 April 2022 | CN | 115885188 | A | 31 March 2023 |
| | | | | EP | 4202463 | A1 | 28 June 2023 |
| | | | | EP | 4202463 | A4 | 17 April 2024 |
| | | | | US | 2023-0243894 | A1 | 03 August 2023 |
| | | | | WO | 2022-080871 | A1 | 21 April 2022 |
| CN | 111751736 | A | 09 October 2020 | CN | 111751736 | B | 05 July 2024 |
| | | | | JP | 2020-161386 | A | 01 October 2020 |
| | | | | JP | 7116701 | B2 | 10 August 2022 |
| | | | | KR | 10-2020-0115146 | A | 07 October 2020 |
| | | | | KR | 10-2650804 | B1 | 25 March 2024 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020240022348